# EUROPEAN PATENT SPECIFICATION

(11) **EP 2 225 603 B1**
(45) Date of publication and mention of the grant of the patent: **25.06.2014**
(21) Application number: 08848846.5
(22) Date of filing: 17.11.2008
(51) Int. Cl.: G02F 1/1333, G02F 1/13357, H05K 7/20

(54) **SYSTEM AND METHOD FOR THERMALLY CONTROLLING AN ELECTRONIC DISPLAY**
SYSTEM UND VERFAHREN ZUM THERMISCHEN REGELN EINES ELEKTRONISCHEN DISPLAYS
SYSTÈME ET PROCÉDÉ POUR RÉGULER THERMIQUEMENT UN AFFICHAGE ÉLECTRONIQUE

(30) Priority: 16.11.2007 US 941728; 03.03.2008 US 33058; 03.03.2008 US 33064; 26.03.2008 US 39454; 16.05.2008 US 53713; 30.05.2008 US 57599; 26.06.2008 US 76126; 14.08.2008 US 191834; 19.09.2008 US 234307; 19.09.2008 US 234360; 22.09.2008 US 235200; 24.09.2008 US 237365; 17.11.2008 US 115333
(43) Date of publication of application: 08.09.2010
(73) Proprietor: Manufacturing Resources International, INC., Alpharetta, GA 30005 (US)
(72) Inventor: DUNN, William, R., Alpharetta GA 30005 (US)
(74) Representative: Winter, Brandl, Fürniss, Hübner, Röss, Kaiser, Polte - Partnerschaft
(86) International application number: PCT/US2008/083792
(87) International publication number: WO 2009/065125

(56) References cited:
- EP-A1- 1 762 892
- WO-A1-2005/079129
- GB-A- 2 402 205
- JP-A- 8 194 437
- JP-A- 2002 158 475
- JP-A- 2005 134 849
- KR-A- 20070 070 675
- US-A- 5 991 153

## Description

### Technical Field

Exemplary embodiments generally relate to heating/cooling systems for electronic displays.

### Background of the Art

Electronic displays are typically used in indoor, temperature-controlled environments. Although the temperature surrounding the display might be relatively stable (near room temperature), the components of the display may generate a large amount of heat. If not properly removed, this heat could damage the display or shorten its lifetime. Conductive and convective heat transfer systems have traditionally been used to remove heat from the electronic components in a display through as many sidewalls of the display as possible. While such heat transfer systems have enjoyed a measure of success in the past, today's electronic displays require even greater cooling (and in some case heating) capabilities.

Modem electronic displays are now being used in outdoor environments as well as other situations where the surrounding temperature may extend above and below room temperature. In addition to heat transfer from the surrounding air, radiative heat transfer from the sun through a display surface may also become a major factor. In some applications and locations, 200 Watts or more of power through such a display surface is common. Furthermore, the market is demanding larger and brighter, sometimes high definition displays. With increased electronic display size more heat will be absorbed from the sun and more heat will be transmitted into the displays. To compete with the ambient light from the sun as well as reflections off surrounding surfaces, displays must produce more light, which also typically results in more heat generated by the display and/or its backlight assembly.

Further, in some applications the temperature may drop well below room temperature. Some components of an electronic display may malfunction or may be permanently destroyed by exposure to such low temperatures. For example, the performance of the liquid crystal material in a liquid crystal display (LCD) may be effected by low temperatures.

The US 5,991,153 discloses an electronic display unit comprising a thermal control system for a display stack of the electronic display unit having a display surface and a backlight assembly. The casing of the electronic display unit forms a closed loop gas cooling system consisting of a first gas chamber arranged in front of the display surface and a second gas chamber being in fluid contact with the first gas chamber and being arranged behind the backlight assembly. The second gas chamber is separated from the backlight assembly by a partition wall. In order to enhance the cooling effect of the thermal control system the rear wall of the second gas chamber is equipped with a cooling element comprising a plurality of cooling fins which are encircled by an air stream generated by an external fan.

GB 2,402 205 A and WO 2005/079 1299 A1 disclose other thermal control systems of this kind for cooling an electronic display unit.

### Summary of the Exemplary Embodiments

It is an object of the present invention to provide a thermal control system and a method for thermally controlling a display stack of an electronic display with an enhanced cooling/heating efficiency. This object is solved by a system according to the patent claim 1 and by a method according to the patent claim 6. Exemplary embodiments may contain one or more of the thermal control features disclosed herein as far as covered by the claims. A plurality of thermal control features are disclosed and these features may be utilized alone or in any combination. The precise combination of features would depend upon the particular cooling/heating needs of the display at issue, which would depend upon the type of display, size of the display, and its particular environment. The thermal control system may be practiced with any form of electronic display, including but not limited to: LCD, light emitting diode (LED), organic light emitting diode (OLED), field emitting display (FED), cathode ray tube (CRT), plasma, and projection displays. An exemplary embodiment would be practiced with LCD displays.

The invention relates to an isolated gas cooling system. The gas cooling system is a closed loop which includes a first gas chamber comprising a transparent anterior plate and a second gas chamber comprising a cooling plenum. The first gas chamber is anterior to and coextensive with the viewable face of the electronic display. The transparent anterior plate may be set forward of the electronic display surface, defining the, depth of the first gas chamber. A cooling chamber fan, or equivalent means, is located within the cooling plenum and is used to propel gas around the isolated gas cooling chamber loop. As the gas traverses the first gas chamber it contacts the electronic display surface, absorbing heat from the display surface. Because the gas and the relevant surfaces of the first gas chamber are transparent, the image quality remains excellent. After the gas has traversed the transparent first gas chamber, the gas may be directed into the rear cooling plenum where it is cooled.

Another thermal feature may utilize the isolated gas system as a heating device, either instead of or in addition to its cooling abilities. An isolated gas heating system would also be a closed loop system with a first gas chamber anterior to the display surface and a second chamber comprising a heating plenum or cooling/heating plenum. Heating elements may be placed within the plenum in order to heat the gas within the second chamber. As the gas is forced into the first chamber it may transfer its heat to the display surface. The gas may then return to the plenum for another heating cycle. The plenum may function as a cooling plenum only, heating plenum only, or a combination heating/cooling plenum; all depending upon the particular display and its particular operating environment.

Some embodiments may place electronic components used to operate the electronic display within the plenum of the isolated gas chamber. The electronic components may include, but are not limited to: transformers, circuit boards, processors, resistors, capacitors, batteries, motors, power supplies, illumination devices, wiring and wiring harnesses, and switches. If the plenum is being utilized as a cooling plenum, the cool gas within the plenum can further aid in the cooling of the electronic components, which will naturally generate heat during operation. Further, if the plenum is being utilized as a source of heat for the display, the natural heat from the electronic components can also heat the gas in the plenum, reducing the amount of energy which needs to be applied to the heating elements.

A linear polarizer may be used in some embodiments to further reduce the solar loading on the electronic display. This polarizer can be used in combination with the isolated gas chamber, or may simply be placed anterior to the electronic display with an insulating gap between the polarizer and the display. The insulating gap reduces the amount of heat that is transferred between the polarizer and the display.

The electronic displays suitable for the invention, such as LCDs for example, require a backlight assembly to produce an image upon the display surface. The backlight assemblies are typically a large source of heat for the display. Thus, some embodiments may utilize a constricted convection system to cool the backlight unit for the display. The constricted convection system may comprise a constricted convection plate which is placed in close proximity to the backlight assembly in order to define a gap. Gas is forced through the gap in *order* to facilitate more efficient cooling of the backlight assembly. In some embodiments a wall of the plenum may constitute the constricted convection plate.

Some examples may also utilize an air curtain device which forces air (either warm or cold) over the exterior surface of the display assembly.

Finally, some examples may use a fluid assembly which contacts a fluid against the display surface in order to cool it. The fluid may be a substantially clear form of coolant fluid which is pumped through an anterior cavity which includes the display surface.

### Brief Description of the Drawings

A better understanding of the exemplary embodiments will be obtained from a reading of the following detailed description and the accompanying drawings wherein identical reference characters refer to identical parts and in which:
**FIGURE 1** is a perspective view of an exemplary arrangement in conjunction with an exemplary electronic display.
**FIGURE 2** is an exploded perspective view of an exemplary embodiment showing components of the isolated gas cooling system.
**FIGURE 3** is top plan view of an exemplary embodiment of the cooling chamber.
**FIGURE** 4 is a front perspective view of an embodiment of the isolated cooling chamber, particularly the transparent anterior surface of first gas chamber.
**FIGURE 5** is a rear perspective view of an embodiment of the isolated cooling chamber, showing optional electrical components placed in the plenum.
**FIGURE 6** is a rear perspective view of an embodiment of the isolated cooling chamber showing surface features that may be included on the plenum
**FIGURE 7** is a top plan view of an exemplary embodiment of the cooling chamber showing surface features that may be included on the plenum.
**FIGURE 8** is a front perspective view of an embodiment of the isolated cooling chamber with included thermoelectric modules.
**FIGURE 9** is a top plan view of an exemplary embodiment of the cooling chamber with included thermoelectric modules.
**FIGURE 10** is an exploded perspective view of an exemplary embodiment showing components of the isolated gas cooling system.
**FIGURE 11** is a top plan view of an exemplary embodiment of the heating chamber.
**FIGURE 12** is a rear perspective view of an embodiment of the heating chamber, showing optional electrical components and heating elements.
**FIGURES 13** **and** **14** are cross-sectional views of exemplary embodiments for utilizing a linear polarizer with the isolated gas system.
**FIGURES 15A and 15B** are side views of examples of a constricted convection cooling system with a constricted convection plate.
**FIGURE 16** is a top plan view of an exemplary embodiment where the cooling plenum is utilized as the constricted convection plate.
**FIGURES 17A-17C** are cross-sectional views of embodiments where the cooling plenum is utilized as the constricted convection plate.

### Detailed Description

It is to be understood that the disclosed embodiments include thermally controlling displays including, but not limited to LCDs. For simple explanation purposes, embodiments may be described with respect to the components for LCD displays. By way of example and not by way of limitation, similar arrangements may be used in conjunction with displays selected from among LCD, light emitting diode (LED), organic light emitting diode (OLED), field emitting display (FED), cathode ray tube (CRT), plasma, and projection displays. Furthermore, similar arrangements may be used with displays other types including those not yet discovered. In particular, it is contemplated that similar arrangements may be well suited for use with full color, flat panel OLED displays. Further, it is particularly contemplated that embodiments may be used with relatively large, high definition LCD displays. While the embodiments described herein are well suited for outdoor environments, they may also be appropriate for indoor applications (e.g:, factory environments, coolers/freezers, etc.) where thermal stability of the display may be at risk.

### Isolated Gas Cooling System

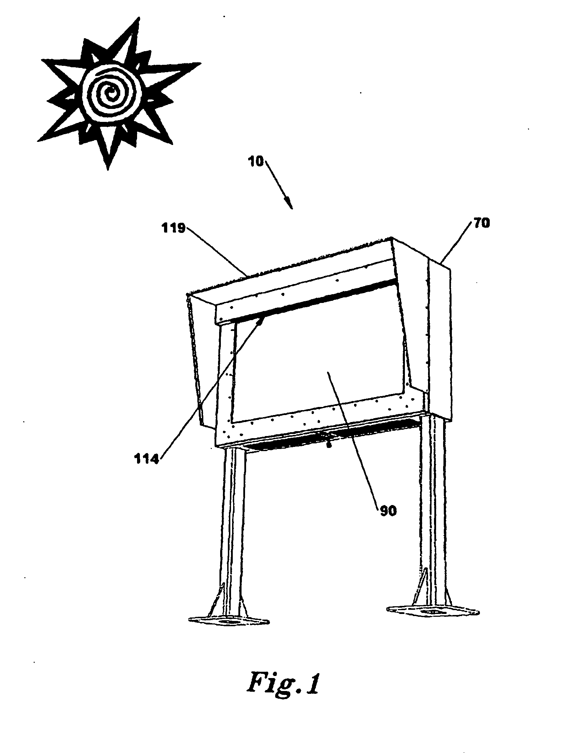

As shown in FIGURE 1, when the display 10 is exposed to outdoor elements, the temperatures inside the display 10 may vary greatly without some kind of cooling device. As such, the display 10 may not function properly or may have a greatly reduced life span. Direct sunlight is especially problematic in causing increases in the internal temperature of the display 10.

In Figure 1, the display area of the electronic display shown includes a narrow gas chamber that is anterior to and coextensive with the electronic display surface. The display shown is also equipped with an optional air curtain device 114. The air curtain device 114 is discussed in detail below. Optionally, the display may have a reflection shield 119, to mitigate reflection of the sunlight on the display surface. Additionally, in outdoor environments, housing 70 is preferably a color which reflects sunlight.

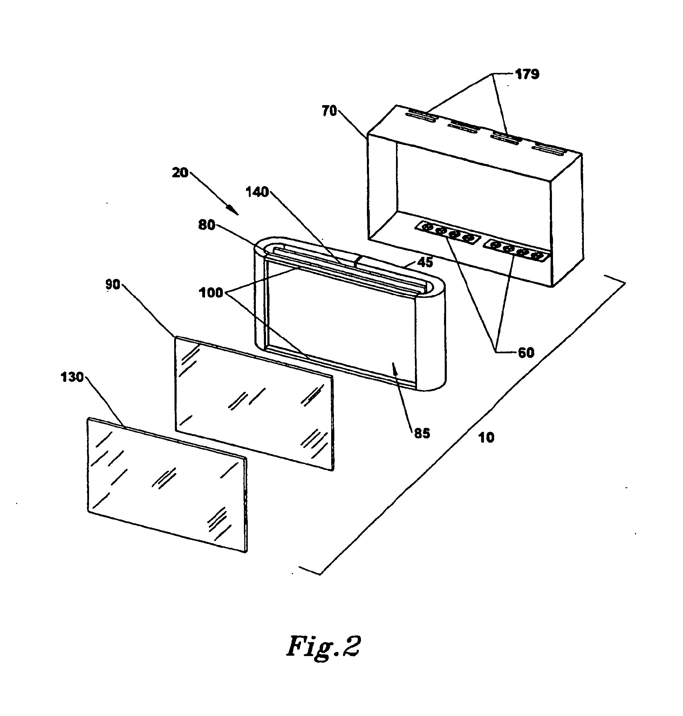

As shown in FIGURE 2, an exemplary embodiment of the electronic display 10 includes an isolated gas cooling chamber 20 contained within a display housing 70. A transparent first gas chamber is defined by spacers 100 and transparent front plate 90. A second transparent front plate 130 may be laminated to front plate 90 to help prevent breakage of front plate 90 and protect the interior of the display. Cooling chamber 20 surrounds a display stack 80 and associated backlight assembly 140.

The display 10 includes means for cooling gas contained within the second gas chamber. These means include one or more fans 60 which may be positioned at the base of the display housing 70. The fans 60 ingest cool air and force the cooler ingested air over at least one external surface of a posterior cooling plenum 45. If desired, an air conditioner (not shown) may also be utilized to cool the air which contacts the external surface of plenum 45. Alternatively, the fans 60 may simply ingest ambient air.

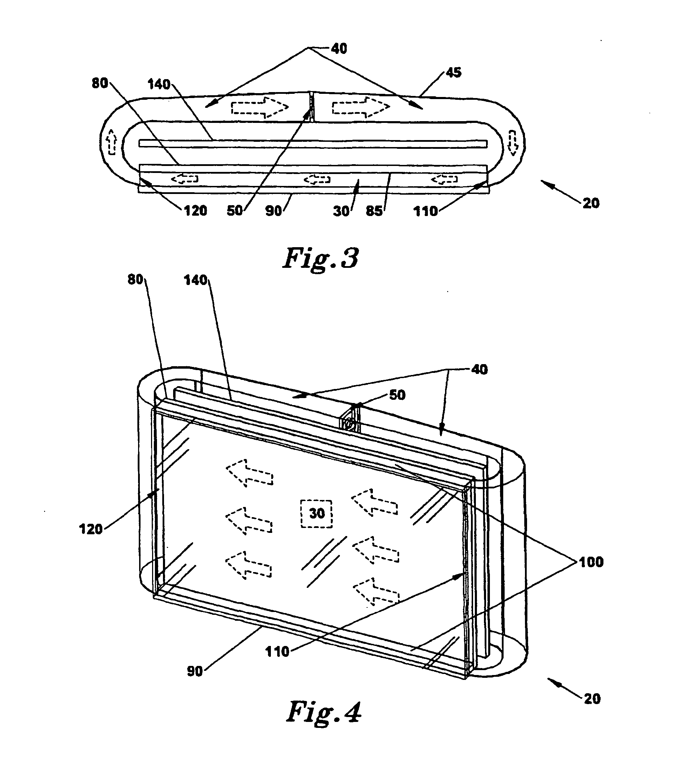

Referring to FIGURE 3, embodiments of the isolated gas cooling chamber 20 comprise closed loop which includes a first gas chamber 30 and a second gas chamber 40. The first gas chamber includes a transparent plate 90. The second gas chamber comprises a cooling plenum 45. The term "isolated gas" refers to the fact that the gas within the isolated gas cooling chamber 20 is isolated from external air in the housing of the display. Because the first gas chamber 30 is positioned in front of the electronic display surface 85, the gas should be substantially free of dust or other contaminates that might negatively affect the display image. An optional filter (not shown) may be utilized to assist in preventing contaminates and dust from entering the first gas chamber 30.

The isolated gas may be almost any transparent gas, for example, normal air, nitrogen, helium, or any other transparent gas. The gas is preferably colorless so as not to affect the image quality.

In the closed loop configuration shown in Fig. 3, the first gas chamber 30 is in gaseous communication with the second gas chamber 40. A cooling chamber fan 50 is provided within the cooling plenum 45 and utilized to propel gas around the isolated gas cooling chamber 20. The first gas chamber 30 includes at least one front glass 90 mounted in front of an electronic display surface 85.

Referring to FIGURE 4, the front plate 90 may be set forward from the electronic display surface 85 by spacing members 100. The spacing members 100 define the depth of the narrow channel passing in front of the electronic display surface 85. The spacing members 100 may be independent or alternatively may be integral with some other component of the device (e.g., integral with the front plate 90). The electronic display surface 85, the spacing members 100, and the transparent front plate 90 define a first gas chamber 30. The chamber 30 is in gaseous communication with plenum 45 through entrance opening 110 and exit opening 120.

As shown in Fig. 3, a posterior surface of the first gas chamber 30 preferably comprises the electronic display surface 85 of the display stack 80. As the isolated gas in the first gas chamber 30 traverses the display it contacts the electronic display surface 85. Contacting the cooling gas directly to the electronic display surface 85 enhances the convective heat transfer away from the electronic display surface 85. In exemplary embodiments the electronic display surface 85 comprises the posterior surface of the first gas chamber 30. Accordingly, the term "electronic display surface" refers to the front surface of a typical electronic display (in the absence of the embodiments disclosed herein).

In an exemplary embodiment, the electronic display surface 85, front plate 90, and optional second front plate 130 may be comprised of a glass substrate. However, neither display surface 85, nor transparent front plate 90, nor optional second transparent front plate 130 need necessarily be glass. Thus, the term "glass" may be used herein interchangeably with the term plate, but a glass material is by no means required. Further, electronic display surface 85 does not have to comprise the posterior surface wall of the front gas compartment 30. An additional plate may be used. However, by utilizing the electronic display surface 85 as the posterior surface wall of the gas compartment 30, there may be fewer surfaces to im pact the visible light traveling through the display. Furthermore, the device will be lighter and cheaper to manufacturer.

Although the embodiment shown utilizes the electronic display surface 85, certain modifications and/or coatings (e.g., anti-reflective coatings) may be added to the electronic display surface 85, or to other components of the system in order to accommodate the coolant gas or to improve the optical performance of the device. In the embodiment shown, the electronic display surface 85 may be the front glass plate of a liquid crystal display (LCD) stack. However, almost any display surface may be suitable for similar arrangements of the present cooling system. Although not required, it is preferable to allow the cooling gas in the first gas chamber 30 to contact the electronic display surface 85 directly. In this way, the convective transfer of heat from the display components to the circulating gas will be maximized.

Referring to Fig. 4, the front plate 90 of the first gas chamber 30 is transparent and is positioned anterior to the electronic display surface 85. The arrows shown represent the movement of the isolated gas through the first gas chamber 30. As shown, the isolated gas traverses the first gas chamber 30 in a horizontal direction. Although cooling system 20 may be designed to move the gas in either a horizontal or a vertical direction, it is preferable to propel the gas in a horizontal direction. In this way, if dust or contaminates do enter the first gas chamber 30, they will tend to fall to the bottom of chamber 30 outside of the viewable area of the display. The system may move air left to right, or alternatively, right to left. After the gas traverses the first gas chamber 30 it exits through exit opening 120. Exit opening 120 defines the entrance junction into the rear cooling plenum 45.

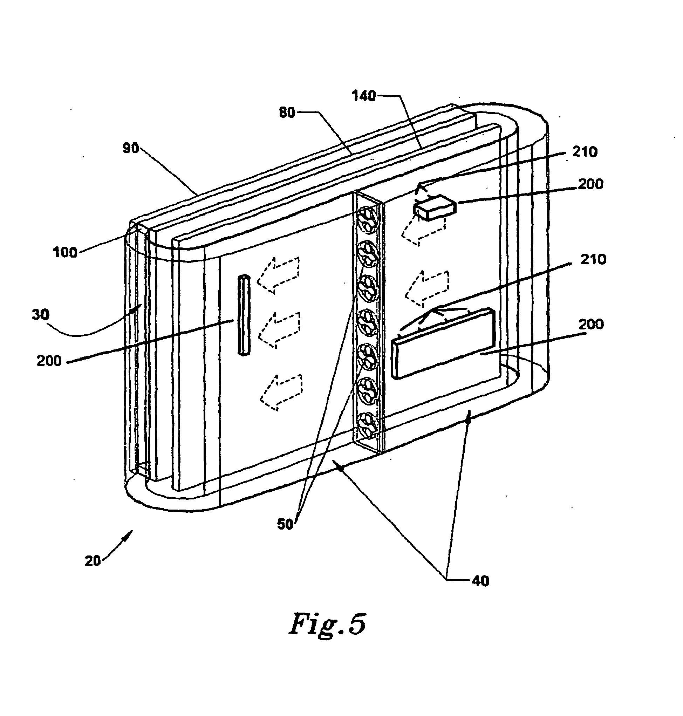

FIGURE 5 shows a schematic of the rear cooling plenum (illustrated as transparent for explanation). One or more fans 50 within the plenum provide the force necessary to move the isolated gas through the isolated gas cooling chamber. Whereas the first gas chamber 30 was designed to collect heat from the surface 85 of the display, the second gas chamber 40 is designed to extract the heat from the gas and remove the heat from the cooling chamber 20. The second chamber 40 may have various contours and features to accommodate the internal structures within a given electronic display application.

If desired, various electronic components 200 can be placed anywhere throughout the second gas chamber 40. The electronic components 200 may include, but are not limited to: transformers, circuit boards, processors, resistors, capacitors, batteries, motors, power supplies, illumination devices, wiring and wiring harnesses, and switches. These components can be mounted directly on the walls of the chamber or supported on rods or posts. Thus, the cooling plenum can be designed to not only extract heat from the first gas chamber 30 but also to cool these various electronic components 200. (Additionally, as discussed below, if the isolated gas system is used to heat the display, the electronic components can assist in heating the isolated gas.)

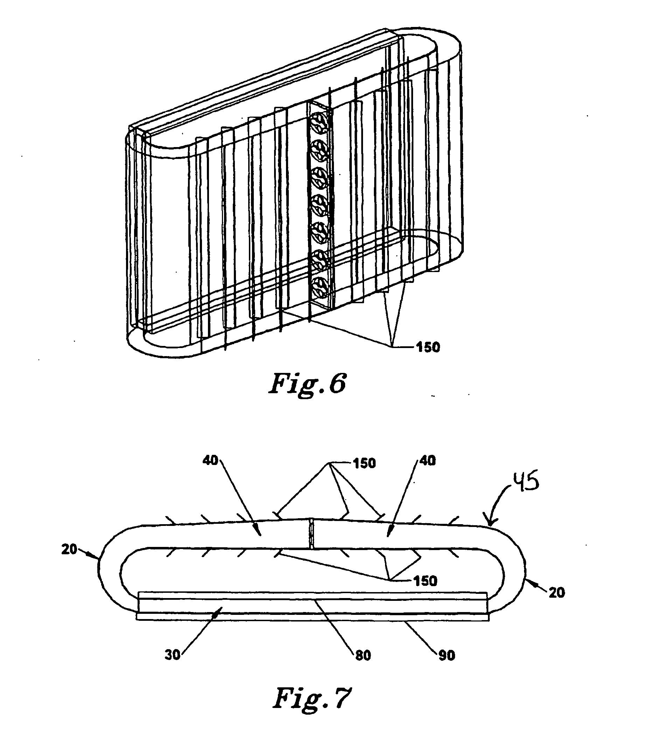

Referring now to FIGURES 6 and 7, various surface features 150 may be added to improve heat dissipation from the plenum 45. These surface features 150 provide more surface area to radiate heat away from the gas within the second gas chamber 40. These features 150 may be positioned at numerous locations on the surface of the plenum 45.

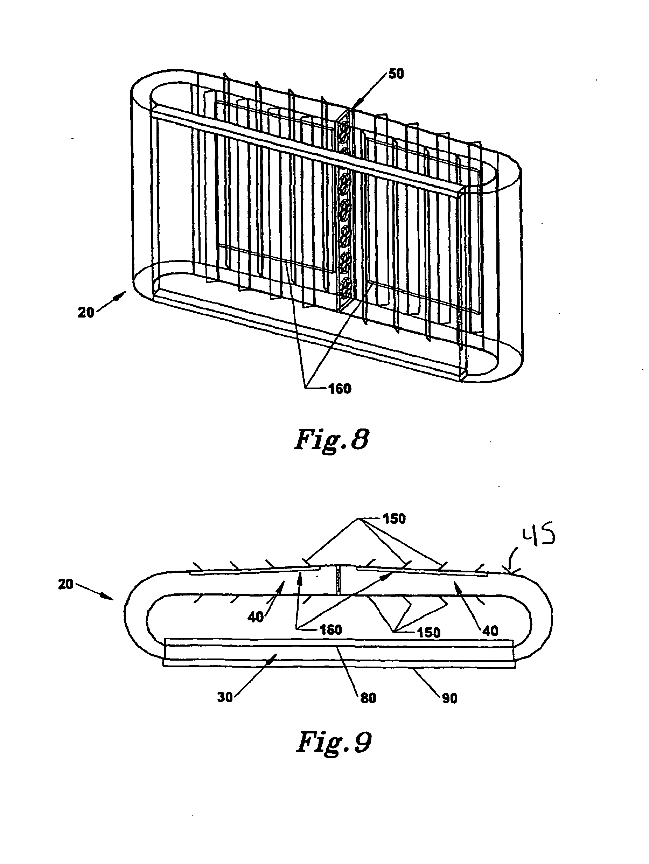

Referring now to FIGURES 8 and 9, one or more thermoelectric modules 160 may be positioned on at least one surface of the plenum 45 to further cool the gas contained in the second gas chamber 40. The thermoelectric modules 160 may be used independently or in conjunction with surface features 150. Alternatively, thermoelectric modules 160 may be used to heat the gas in the plenum if the isolated gas system is utilized to heat a display in a cold environment.

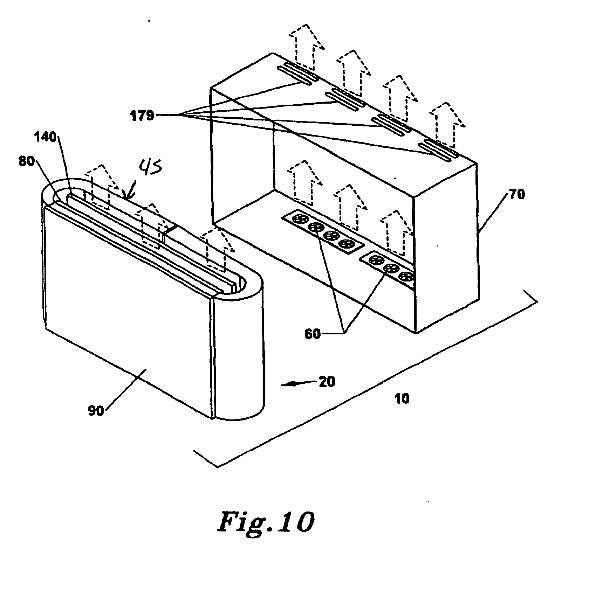

FIGURE 10 shows an exemplary, method for removing heat in the gas contained in the rear plenum 45. Fan 60 is positioned to ingest air and blow that air across the anterior and posterior surfaces of the plenum 45. Again, fan 60 may ingest air conditioned air into the display housing 70 or may simply ingest ambient surrounding air. Furthermore, in this configuration, fan 60 may also force air past the heat generating components of the electronic display (e.g., the display stack 80 and the backlight assembly 140) to further improve the ability to cool the entire display. It should be noted that this embodiment can be combined with the constricted convection cooling method discussed in detail below. The heated exhaust air may exit through one or more apertures 179 located on the display housing 70.

### Isolated Gas Heating System

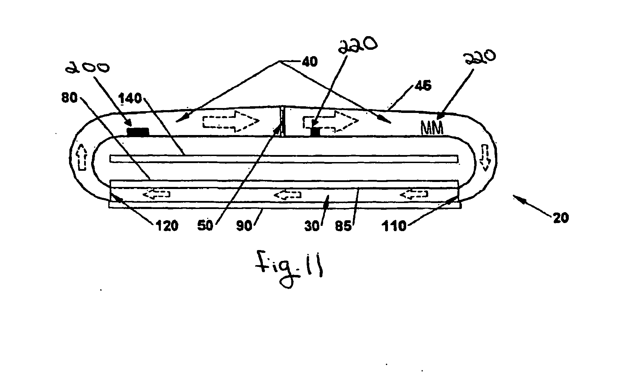

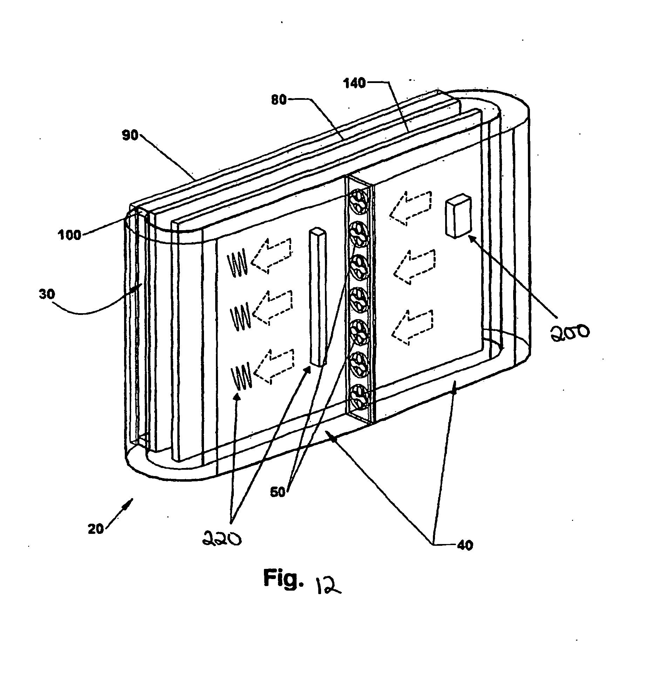

As mentioned above, the isolated gas system can be utilized to also heat the electronic display. Referring to FIGURES 11 and 12, heating elements 220 may be located within the second gas chamber 40 and operate to warm the gas as it passes through the second gas chamber 40. These heating elements can be any one of the many commonly available heating elements or thermoelectric modules. Many times, these elements are simply a material which contains a high electrical resistance, and thus generates heat when current flows through it. The heating elements can be, but are not limited to, any one of the following: nichrome wire or ribbon, screen printed metal/ceramic tracks deposited on ceramic insulated metal (generally steel) plates, CalRod (typically a fine coil of nichrome wire in a ceramic binder, sealed inside a tough metal shell), heat lamp, and Positive Thermal Coefficient (PTC) of resistance ceramic.

As discussed above, the plenum 45 may contain electrical components 200 which power and control the electronic display. The electrical components may be any one of the following: transformers, microprocessors, printed circuit boards, power supplies, resistors, capacitors, motors, wiring harnesses, and connectors. The electrical connections for the electrical components 200 may pass through a wall of the plenum 45. The electrical components 200 can be located anywhere within the plenum 45. The electrical components 200 may be mounted on the posterior or anterior surface of the plenum and may be mounted directly on the surface of the plenum or may be suspended by mounting posts so that gas may pass all around the component.

While the display is operational, the isolated gas cooling system may run continuously. However, if desired, a temperature sensor (not shown) and a switch (not shown) may be incorporated within the electronic display. Thus, a thermostat may be used to detect when temperatures have reached a predetermined threshold value and the isolated gas system may be selectively engaged when the temperature in the display reaches a predetermined value. Predetermined temperature thresholds may be selected and the system may be configured to heat, cool, or both heat and cool the display to advantageously keep the display within an acceptable temperature range.

### Linear Polarizer with Optional Insulator Gap

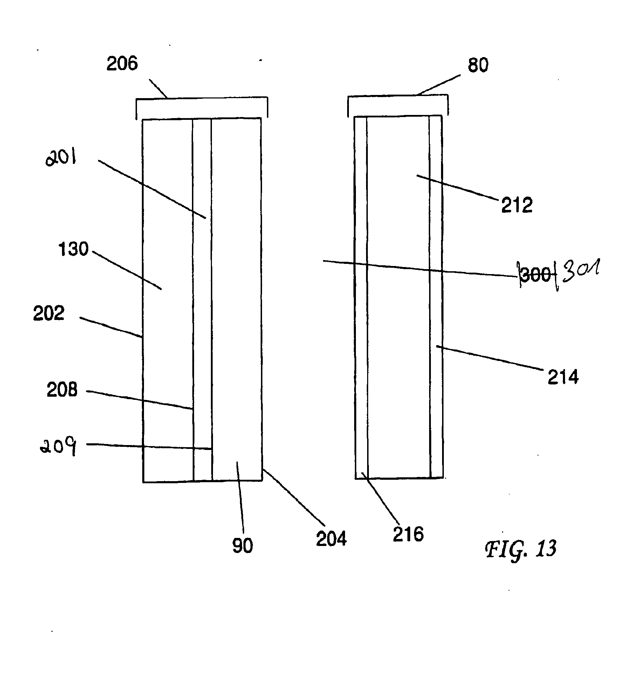

FIGURE 13 is a cross-sectional view of another exemplary embodiment for another thermal control feature. In the arrangement shown, the front plate 90 and a second front plate 130 may be comprised of glass and may be laminated together. The first and second front panels 130 and 90 may be fixed to one another with a layer of index matched optical adhesive 201 to form a front glass unit 206. The display stack 80 may comprise a liquid crystal assembly 212 interposed between a front polarizer 216 and a rear polarizer 214. In other embodiments, the display stack 80 may be any other type of assembly for any other type of electronic display. The space between the display stack 80 and the front glass unit 206 defines an insulator gap 301. The insulator gap 301 serves to thermally separate the front glass unit 206 from the LCD stack 80. This thermal separation localizes the heat on the front glass unit rather than allowing solar loading of the LCD stack. In combination with the isolated gas system, the insulator gap 301 comprises the first gas chamber 30.

The second front panel may have a first surface 202 and a second surface 208. The first surface 202 may be exposed to the elements; while the second surface 208 may be fixed to the first front plate 90 by the index matched optical adhesive 201. The first front plate 90 may have a third surface 209 and a fourth surface 204. The third surface 209 may be fixed to the second front plate 130 by the index matched optical adhesive 201; while the fourth surface may be directly adjacent to the insulator gap 301. In some embodiments, to decrease the solar loading of the display stack 80 and improve the viewable image quality, an anti-reflective coating may be applied to the first surface 202 and the fourth surface 204. In other embodiments, the anti-reflective coating may only be applied to at least one of the first, second, third, or fourth surface 202, 208, 209, and 204, respectively.

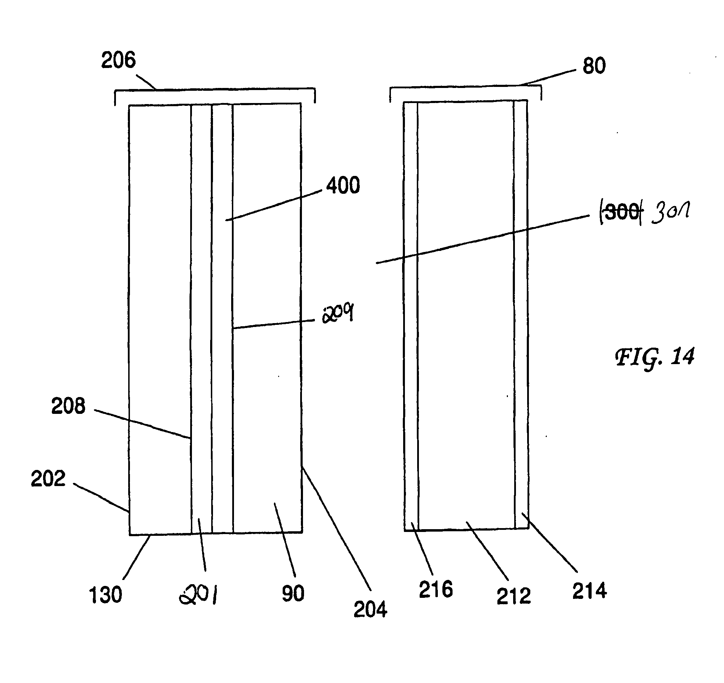

FIGURE 14 is a cross-sectional view of another exemplary embodiment of the front glass unit 206. In the arrangement shown, the front glass unit 206 comprises a second front plate 130, a layer of index matched optical adhesive 201, a linear polarizer 400, and a first front plate 90. The linear polarizer 400 may be bonded to at least one of the first, second, third or fourth surfaces 202, 208, 209, and 204, respectively. Again, anti-reflective layers may be applied to at least one of the first, second, third or fourth surfaces 202, 208, 209, and 204, respectively. The linear polarizer 400 may be aligned with the front polarizer 209 found in the LCD stack 85. The inclusion of a linear polarizer 400 in the front glass unit 206, further decreases the solar load on the display stack 80. The reduction in solar loading may significantly reduce the internal temperature of the electronic display. The linear polarizer 400 may also cause a reduction in specular reflection of the front glass unit 206 and the display stack 80. As discussed above, in combination with the isolated gas system, the insulator gap 301 comprises the first gas chamber 30. Again, it should be noted that the display stack 80 may be an LCD stack, but it can also be any other type of electronic display.

It should also be noted that the second front plate 130 is not required. Embodiments may utilize only the first front plate 90 with a linear polarizer attached to either the posterior or anterior surface of the front plate 90. An anti-reflective layer may also be attached to either the anterior or posterior surface of the front plate 90. The front plate 90 may be tempered for additional strength if using only the front plate 90 without the second front plate 130.

### Constricted Convection

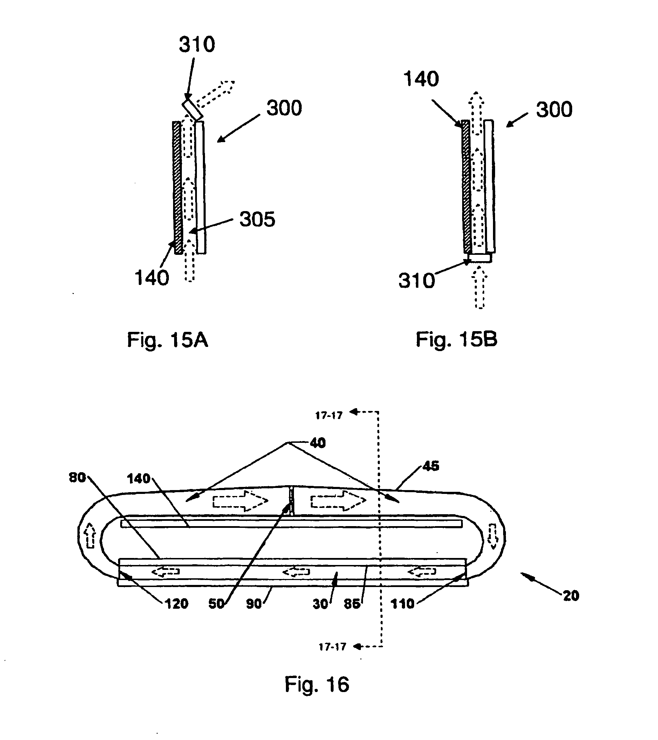

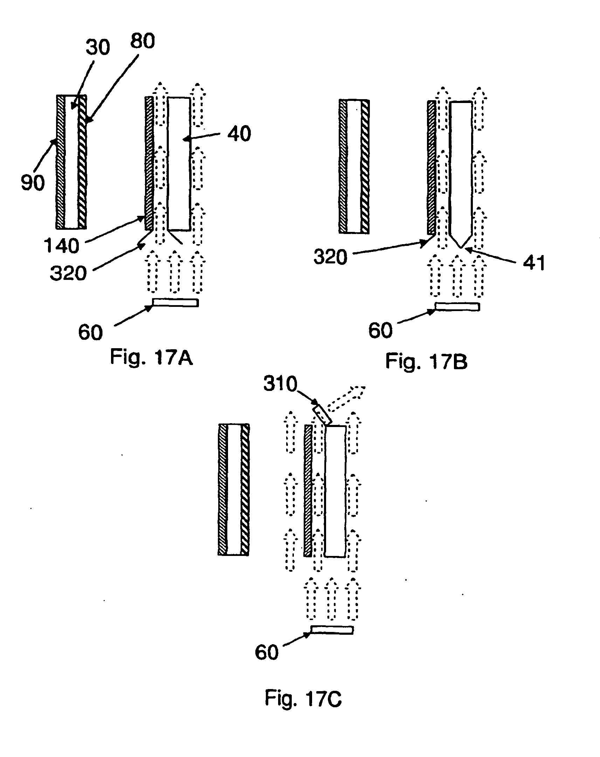

The types of electronic displays in accordance with the present invention require a backlight assembly in order to generate an image upon a viewable screen. LCDs are one type of display that requires a backlight assembly. Other types of displays, such as plasma displays and OLEDs, do not require a backlight assembly as they generate light themselves. However, these types of displays still generate a significant amount of heat. Thus, in the following description, a constricted convection system will be described with regard to a backlight assembly, but it should be noted that similar arrangements can be practiced with other types of displays. Therefore, when a backlight or backlight assemblies are discussed, these backlight assemblies could also be the rear surfaces of other heat-generating displays and the constricted convection system would facilitate more efficient cooling of these alternate displays. It should also be noted that Figures 15A-15B and Figures 17A-17C are not necessarily drawn to scale. The relationship between the elements may be exaggerated for explanatory purposes.

FIGURE 15A shows a cross-sectional view of the backlight 140 with a constricted convection plate 300, the space between the two features defines a narrow gap 305. The dimensions of the gap may vary depending on several factors including the size of the display, its operating conditions, the type of backlight assembly and its posterior surface material, and the number and power applied to the various constricted convection fans. Some examples may utilize a gap distance of approximately 0.25-3.5 inches. Other examples may utilize a slightly larger gap. It has been found that forcing air through this gap 305 increases the ability to cool the backlight 140. One or more constricted convection fans 310 may be used to pull air through the gap 305. FIGURE 15B shows a cross-sectional view of another example for the constricted convection system where one or more constricted convection fans 310 push air through the gap 305.

FIGURE 16 shows a top view of the isolated gas system as discussed above. The cross-section line 17-17 is shown passing through the isolated gas system.

FIGURES 17A-17C show cross-sectional views of the 17-17 section that is shown in Figure 16. Referring first to Figure 17A, towards the front of the display is the first gas chamber 30 which abuts against the electronic display 80. Anterior to the first gas chamber 30 is the front plate 90. Towards the rear of the display, the backlight 140 is placed in close proximity to the second gas chamber 40. In this arrangement, the outer wall of the second gas chamber 40 may function as the constricted convection plate. This arrangement does not utilize a constrictive convection fan, but instead uses the fan 60 which ingest air from outside the display housing and forces it over the surfaces of the second gas chamber 40. As noted above, this air may simply be ambient air or alternatively this air may come from a conditioning unit (not shown). To facilitate the flow of air between the backlight 140 and the cooling chamber 40, a guiding device 320 may be used.

Referring now to Figure 17B, the cooling chamber 40 contains a guiding feature 41, which is used in combination with the guiding device 320 to facilitate the flow of air between the backlight and the cooling chamber. Figure 17C shows an embodiment, where both the external fan 60 and the constrictive convection fan 310 is used. This embodiment could also utilize a version of the guiding devices shown in Figures 17A and 17B.

The backlight 140 may comprise a printed circuit board (PCB) with a plurality of lights mounted to the side facing the electronic display 80. The lights in the backlight may be any one of the following: LED's, organic light emitting diodes (OLED), field emitting display (FED), light emitting polymer (LEP), or organic electro-luminescence (OEL) lights. In an exemplary embodiment, the backlight 140 would ideally have a low level of thermal resistance between the side facing the electronic display 80 and the side facing the second gas chamber. To accomplish this low level of thermal resistance, the backlight 140 may be built using metal printed circuit board (PCB) technology to further transfer heat away from the lights. The rear surface of the backlight 140 may also be metallic, or some other thermally conductive material, to further enhance the convective heat transferring properties. The surface may even have a plurality of surface features such as fins to further enhance the convective heat transferring properties. The constrictive convective fan 310 may then send the warm air out of an exhaust 179 (shown in Figure 2) so that it may exit the display housing entirely.

While the display is operational, the external fan 60 and the constrictive convection fan 310 may run continuously. However, if desired, a temperature sensor (not shown) and a switch (not shown) may be incorporated within the electronic display. This effective thermostat may be used to detect when temperatures have reached a predetermined threshold value. In such a case, the various fans may be selectively engaged when the temperature in the display reaches a predetermined value. Predetermined thresholds may be selected and the system may be configured with a thermostat (not shown) to advantageously keep the display within an acceptable temperature range. This would save on both energy costs as well as the useful lifetime of the devices.

It should be noted, that an air curtain, which is not part of the claimed invention, can be practiced with any type of electronic display and with any combination of the thermal control features described above. Various internal features (not shown) may be placed within a cavity to direct the air towards the baffles 114. The ingested air may continue through the cavity until it reaches the baffles which may direct the air against the exterior display surface. This exterior surface may be the first front plate 90, or alternatively, any of the additional front plates which are described in detail above (ex. second front plate 130).

Thus, the air curtain can be used as an exhaust for the cooling of internal components of the display. Alternatively, the cool air from the air curtain can be used to further cool the exterior front surface of the display which may be subjected to significant solar loading or heat transfer from ambient hot air.

Another thermal control feature, which is not part of the claimed invention, may comprise a cooling system which includes various components in fluid communication. Preferably, this may be accomplished by connecting the components with a series of tubes or pipes. The cooling system components include a reservoir tank, a pump, and a cooling chamber in fluid communication. Preferably, the system also includes a filter and a radiator, also in fluid communication. Optionally, the system may also include a fan unit. However, the optional fan unit is preferably not in fluid communication with the other components.

As one skilled in the art will appreciate, other methods and devices may also be used to regulate the flow through a cooling chamber. For example, the size and pump speed of the pump may be optimized for a given application. Alternatively, a variable speed pump may also be used. Preferably, the variable speed pump may be in electrical communication with at least one pressure transducer (not shown). Preferably, a pressure transducer may be placed upstream of the cooling chamber and another pressure transducer may be placed downstream of the cooling chamber. The pressure information provided by the at least one pressure transducer may be utilized to set the operating speed of the variable speed pump. In that way, the flow rate through the cooling chamber may be adjusted to maintain appropriate pressures in the device. Maintaining appropriate pressures in the cooling chamber is important for preventing deformation or breakage of the display glass.

An optional filter may be added to remove contamination in the fluid. Preferably, a radiator and fan unit may also be included to provide even greater thermal stability. Optionally, a spigot (not shown) may be provided to facilitate the process of filling and emptying the coolant fluid from the system.

If desired, fan units may be located at the base of the housing just behind the cooling chamber of display. Fan units may provide a laminar flow of air through the interior of the housing. Preferably, the airflow will be directed across at least one external surface of reservoir tank. As described above, the air exhaust flow may ultimately be redirected onto the cooling chamber surface by way of an optional air curtain system.

If desired, a temperature sensor (not shown) and a switch (not shown) may be incorporated within the electronic display. The temperature sensor may be used to detect when temperatures have reached a predetermined threshold value. In such a case, the pump can be selectively engaged when the temperature in the display meets a predetermined value. Predetermined thresholds may be selected and the system may be configured with a thermostat (not shown) to advantageously keep the display at a relatively constant temperature, or at least within a range of acceptable temperatures. Alternatively, to avoid the need for a thermostat, the pump may run continuously when the electronic display is operational.

## Claims

1. A thermal control system for a display stack (80) having a display surface (85) and for a backlight assembly (140), the system comprising:
an isolated gas cooling chamber (20) comprising a closed loop having a first gas chamber (30) positioned anterior to the display surface (85), and a second gas chamber (40) in gaseous communication with an entrance (110) and an exit (120) of said first gas chamber (30) and positioned posterior to the backlight assembly (140), said second gas chamber (40) having interior and exterior surfaces, wherein the gas within the isolated gas cooling chamber (20) is isolated from external air;
one or more chamber fans (50) within said second gas chamber (40) to propel gas around the first and second gas chambers; and **characterized by**
one or more fans (60) adapted to force air over at least one exterior surface of the second gas chamber (40) and between the backlight assembly (140) and an exterior surface of the second gas chamber (40).

2. The system of claim 1, further comprising:
one or more of the electronic components (200) for operating the display stack (80), contained within said second gas chamber (40).

3. The system of claim 1, further comprising:
one or more heating elements (220) within the second gas chamber (40).

4. The system of any one of claims 1 to 3, further comprising:
a linear polarizer (400) placed anterior to said display surface (85).

5. The system of any one of claims 1 to 4, wherein:
said exterior surface of the second gas chamber (40) is in close proximity to the rear surface of said backlight assembly (140); and comprising
one or more additional constricted convection fans (310) adapted to draw air between the exterior surface of the second gas chamber (40) and the rear surface of said backlight assembly (140).

6. The system of claim 1 further comprising:
a plurality of surface features (150) on the exterior surfaces of the second gas chamber (40).

7. The system of claim 4, further comprising:
a first front plate (90) and second front plate (130) surrounding the linear polarizer (400).

8. A method for thermally controlling a display stack (80) having a display surface (85) and a backlight assembly (140), comprising the steps of:
providing an isolated gas system having an isolated gas cooling chamber (20) comprising a closed loop having a first gas chamber (30) which includes the display surface (85), and a second gas chamber (40) in gaseous communication with said first gas chamber (30); wherein the gas within the isolated gas cooling chamber (20) is isolated from external air, the second gas chamber (40) having exterior surfaces and placed adjacent to the rear surface of the backlight assembly (140);
forcing isolated gas into the first gas chamber (30);
directing the isolated gas into the second gas chamber (40);
**characterized by** forcing cooling gas over at least one exterior surface of the second gas chamber (40) and between the rear surface of the backlight assembly (140) and an exterior surface of the second gas chamber (40) by one or more fans (60);
and
reintroducing the isolated gas into the first gas chamber (30).

9. The method of claim 8, further comprising the step of:
heating the isolated gas within the second chamber (40) if heating is desired.

10. The method of one of claims 8 and 9, further comprising the steps of:
providing said exterior surface of the second gas chamber (40) is in close proximity to the backlight assembly (140), the area between the exterior surface of the second gas chamber (40) and the backlight assembly (140) defining a gap (305); and
drawing air through said gap (305) in order to cool the posterior portion of the backlight assembly (140) by additional constricted convection fans (310).

## Patentansprüche

1. Thermisches Steuersystem für einen Anzeigestapel (80), der eine Anzeigeoberfläche (85) aufweist, und für eine Hintergrundbeleuchtungsanordnung (140), wobei das System umfasst:
eine isolierte Gaskühlkammer (20), die einen geschlossenen Kreislauf aufweist, der eine erste Gaskammer (30), die vor der Anzeigeoberfläche (85) positioniert ist, und eine zweite Gaskammer (40) aufweist, die in gasförmiger Kommunikation mit einem Einlass (110) und einem Auslass (120) der ersten Gaskammer (30) steht und hinter der Hintergrundbeleuchtungsanordnung (140) positioniert ist, wobei die zweite Gaskammer (40) innere und äußere Oberflächen aufweist, wobei das Gas innerhalb der isolierten Gaskühlkammer (20) gegenüber externer Luft isoliert ist;
ein oder mehrere Kammergebläse (50) innerhalb der zweiten Gaskammer (40), um Gas um die erste und zweite Gaskammer herum zu bewegen; und **gekennzeichnet durch**
einen oder mehrere Lüfter (60), die dazu ausgelegt sind, Luft über mindestens eine äußere Oberfläche der zweiten Gaskammer (40) und zwischen der Hintergrundbeleuchtungsanordnung (140) und einer äußeren Oberfläche der zweiten Gaskammer (40) zwangsweise zu fördern.

2. System nach Anspruch 1, das weiterhin aufweist:
eine oder mehrere der elektronischen Komponenten (200) für den Betrieb des Anzeigestapels (80), die innerhalb der zweiten Gaskammer (40) enthalten sind.

3. System nach Anspruch 1, das weiterhin aufweist:
ein oder mehrere Heizelemente (23) innerhalb der zweiten Gaskammer (40).

4. System nach einem beliebigen der Ansprüche 1 bis 3, das weiterhin umfasst:
einen linearen Polarisator (400), der vor der Anzeigeoberfläche (85) angeordnet ist.

5. System nach einem beliebigen der Ansprüche 1 bis 4, wobei:
die äußere Oberfläche der zweiten Gaskammer (40) sich in enger Nachbarschaft zu der rückseitigen Oberfläche der Hintergrundbeleuchtungsanordnung (140) befindet; und das aufweist:
einen oder mehrere zusätzliche Lüfter (310) mit begrenzter Konvektion, die dazu ausgelegt sind, Luft zwischen der äußeren Oberfläche der zweiten Gaskammer (40) und der rückseitigen Oberfläche der Hintergrundbeleuchtungsanordnung (140) anzusaugen.

6. System nach Anspruch 1, das weiterhin umfasst:
eine Mehrzahl von Oberflächenmerkmalen (150) auf den äußeren Oberflächen der zweiten Gaskammer (40).

7. System nach Anspruch 4, das weiterhin umfasst:
eine erste Frontplatte (90) und eine zweite Frontplatte (130), die den linearen Polarisator (400) umgeben.

8. Verfahren für die thermische Steuerung eines Anzeigestapels (80), der eine Anzeigeoberfläche (85) und eine Hintergrundbeleuchtungsanordnung (140) aufweist, das die Schritte umfasst:
Bereitstellen eines isolierten Gassystems, das eine isolierte Gaskühlkammer (20), die einen geschlossenen Kreislauf aufweist, der eine erste Gaskammer (30), die die Anzeigeoberfläche (85) aufweist, und eine zweite Gaskammer (40) umfasst, die in gasförmiger Kommunikation mit der ersten Gaskammer (30) steht; wobei das Gas innerhalb der isolierten Gaskühlkammer (20) gegenüber externer Luft isoliert ist, und die zweite Gaskammer (40) äußere Oberflächen aufweist und benachbart zu der rückseitigen Oberfläche der Hintergrundbeleuchtungsanordnung (140) platziert ist;
zwangsweises Fördern von isoliertem Gas in die erste Gaskammer (30);
Richten des isolierten Gases in die zweite Gaskammer (40);
**gekennzeichnet durch** das zwangsweise Fördern von kühlendem Gas über mindestens eine äußere Oberfläche der zweiten Gaskammer (40) und zwischen der
hinteren Oberfläche der Hintergrundbeleuchtungsanordnung (140) und einer äußeren Oberfläche der zweiten Gaskammer (40) **durch** ein oder mehrere Gebläse (60); und
erneutes Einführen des isolierten Gases in die erste Gaskammer (30).

9. Verfahren nach Anspruch 8, das weiterhin den Schritt umfasst:
Erwärmen des isolierten Gases innerhalb der zweiten Kammer (40), falls eine Erwärmung gewünscht ist.

10. Verfahren nach einem der Ansprüche 8 und 9, das weiterhin die Schritte umfasst:
Bereitstellen der äußeren Oberfläche der zweiten Gaskammer (40) derart, dass sie sich in enger Nachbarschaft zu der Hintergrundbeleuchtungsanordnung (140) befindet, wobei die Fläche zwischen der äußeren Oberfläche der zweiten Gaskammer (40) und der Hintergrundbeleuchtungsanordnung (140) einen Spalt (305) definiert; und
Einsaugen von Luft durch den Spalt (305) für eine Kühlung des hinteren Abschnitts der Hintergrundbeleuchtungsanordnung (140) durch zusätzliche Lüfter (310) mit begrenzter Konvektion.

## Revendications

1. Système de régulation thermique pour un empilement d'affichages (80) ayant une surface d'affichage (85) et pour un ensemble de rétroéclairage (140), le système comprenant :
une chambre de refroidissement à gaz isolé (20) comprenant une boucle fermée ayant une première chambre à gaz (30) positionnée avant la surface d'affichage (85) et une seconde chambre à gaz (40) en communication gazeuse avec une entrée (110) et une sortie (120) de ladite première chambre à gaz (30) et positionnée derrière l'ensemble de rétroéclairage (140), ladite seconde chambre à gaz (40) ayant des surfaces intérieure et extérieure, dans lequel gaz à l'intérieur de la chambre de refroidissement à gaz isolé (20) est isolé de l'air extérieur ;
une ou plusieurs ailettes de chambre (50) à l'intérieur de ladite seconde chambre à gaz (40) pour propulser le gaz autour des première et seconde chambres à gaz ; et **caractérisé par** :
un ou plusieurs ventilateurs (60) adaptés pour forcer l'air sur au moins une surface extérieure de la seconde chambre à gaz (40) et entre l'ensemble de rétroéclairage (140) et une surface extérieure de la seconde chambre à gaz (40).

2. Système selon la revendication 1, comprenant en outre :
un ou plusieurs des composants électroniques (200) pour actionner l'empilement d'affichages (80) contenus à l'intérieur de ladite seconde chambre à gaz (40).

3. Système selon la revendication 1, comprenant en outre :
un ou plusieurs éléments chauffants (220) à l'intérieur de la seconde chambre à gaz (40).

4. Système selon l'une quelconque des revendications 1 à 3, comprenant en outre :
un polariseur linéaire (400) placé devant ladite surface d'affichage (85).

5. Système selon l'une quelconque des revendications 1 à 4, dans lequel :
ladite surface extérieure de la seconde chambre à gaz (40) est à proximité immédiate de la surface arrière dudit ensemble de rétroéclairage (140) ; et comprenant :
un ou plusieurs ventilateurs de convection étroits supplémentaires (310) adaptés pour aspirer l'air entre la surface extérieure de la seconde chambre à gaz (40) et la surface arrière dudit ensemble de rétroéclairage (140).

6. Système selon la revendication 1, comprenant en outre :
une pluralité de caractéristiques de surface (150) sur les surfaces extérieures de la seconde chambre à gaz (40).

7. Système selon la revendication 4, comprenant en outre :
une première plaque avant (90) et une seconde plaque avant (130) entourant le polariseur linéaire (400).

8. Procédé pour réguler thermiquement un empilement d'affichages (80) ayant une surface d'affichage (85) et un ensemble de rétroéclairage (140), comprenant les étapes consistant à :
prévoir un système à gaz isolé ayant une chambre de refroidissement à gaz isolé (20) comprenant une boucle fermée ayant une première chambre à gaz (30) qui comprend la surface d'affichage (85) et une seconde chambre à gaz (40) en communication gazeuse avec ladite première chambre à gaz (30) ; dans lequel le gaz à l'intérieur de la chambre de refroidissement à gaz isolé (20) est isolé de l'air extérieur, la seconde chambre à gaz (40) ayant des surfaces extérieures et placée de manière adjacente à la surface arrière de l'ensemble de rétroéclairage (140) ;
forcer le gaz isolé dans la première chambre à gaz (30) ;
diriger le gaz isolé dans la seconde chambre à gaz (40) ;
**caractérisé par** l'étape consistant à forcer le gaz de refroidissement sur au moins une surface extérieure de la seconde chambre à gaz (40) et entre la surface arrière de l'ensemble de rétroéclairage (140) et une surface extérieure de la seconde chambre à gaz (40) par un ou plusieurs ventilateurs (60) ;
et
réintroduire le gaz isolé dans la première chambre à gaz (30).

9. Procédé selon la revendication 8, comprenant en outre l'étape consistant à :
faire chauffer le gaz isolé à l'intérieur de la seconde chambre (40) si le chauffage est souhaité.

10. Procédé selon l'une des revendications 8 et 9, comprenant en outre les étapes consistant à :
prévoir ladite surface extérieure de la seconde chambre à gaz (40) à proximité immédiate de l'ensemble de rétroéclairage (140), la zone entre la surface extérieure de la seconde chambre à gaz (40) et l'ensemble de rétroéclairage (140) définissant un espace (305) ; et
aspirer l'air par ledit espace (305) afin de faire refroidir la partie postérieure de l'ensemble de rétroéclairage (140) par des ventilateurs de convection étroits supplémentaires (310).
